# FASCICULE DE BREVET EUROPEEN

(11) **EP 4 298 417 B1**
(45) Date de publication et mention de la délivrance du brevet: **30.07.2025**
(21) Numéro de dépôt: 22707439.0
(22) Date de dépôt: 23.02.2022
(51) Int. Cl.: G01L 21/34, C23C 14/54, H01J 41/06, C23C 14/34, C23C 14/56

(54) **SYSTÈME EMBARQUÉ POUR MESURE DE PRESSION DE VIDE RÉSIDUEL ET MÉTHODE DE DIAGNOSTIC DU VIDE SECONDAIRE DANS UNE LIGNE DE DÉPÔTS DE COUCHES MINCES**
BORDSYSTEM ZUR MESSUNG EINES RESTVAKUUMDRUCKS UND VERFAHREN ZUR DIAGNOSE DES SEKUNDÄRVAKUUMS IN EINER DÜNNSCHICHTABSCHEIDUNGSLINIE
ON-BOARD SYSTEM FOR MEASURING A RESIDUAL VACUUM PRESSURE AND METHOD FOR DIAGNOSING SECONDARY VACUUM IN A THIN-FILM DEPOSITION LINE

(30) Priorité: 25.02.2021 FR 2101859
(43) Date de publication de la demande: 03.01.2024
(73) Titulaire: Saint-Gobain Glass France, 92400 Courbevoie (FR)
(72) Inventeur: KHARCHENKO, Andriy, 91120 PALAISEAU (FR)
(74) Mandataire: Saint-Gobain Recherche
(86) Numéro de dépôt international: PCT/EP2022/054505
(87) Numéro de publication internationale: WO 2022/180085

(56) Documents cités:
- EP-A2- 0 413 291
- WO-A1-2019/110948
- FR-A- 1 485 659
- US-A- 2 643 342

## Description

### Domaine technique

L'invention se rapporte à un système embarqué comprenant un dispositif de mesure de pression de vide secondaire.

L'invention est particulièrement adaptée pour la mesure de pression de vide secondaire dans les compartiments des lignes de dépôt d'empilement de couches minces sur substrats plans.

L'invention a également pour objet à une méthode de diagnostic du vide dans une ligne de dépôt de couches minces et dans laquelle un système embarqué de contrôle de vide est utilisé.

### Arrière-plan technique

Les méthodes de dépôt par pulvérisation cathodique assistée par champ magnétique sont couramment utilisées pour de nombreuses applications commerciales d'empilement de couches minces, telles que les empilements dits « contrôle solaire » pour le bâtiment et l'automobile.

Concrètement, un empilement de couches minces est fabriqué par des dépôts successifs de couches minces effectués dans une pluralité de compartiments, généralement isolés les uns des autres, d'une ligne de dépôt. Des exemples de ligne de dépôt sont décrits dans US4009090A, US2005236276A1.

Le brevet US2643342 divulgue un manomètre à ionisation à cathode froide et la demande de brevet FR1485659 expose des mesures de nanomètre à ionisation à cathode froide.

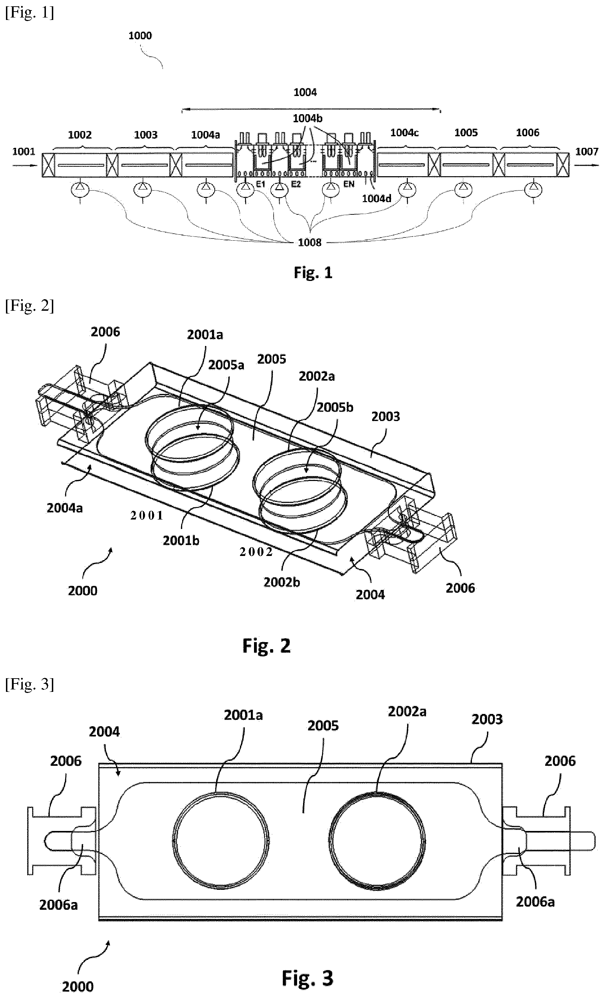

En référence à la fig. 1, une ligne de dépôt 1000 comprend plusieurs compartiments 1002-1006 à travers lesquels un substrat 1001 est successivement transporté. La ligne de dépôt comprend un compartiment d'entrée 1002, un premier compartiment de transfert 1003, une section de dépôt 1004, un deuxième compartiment de transfert 1005 et un compartiment de sortie 1006 duquel sort le substrat 1007 sort revêtu d'un empilement de couches minces.

La section de dépôt 1004 comprend deux compartiments de transfert 1004a, 1004b et une succession 1004b de compartiments de dépôt Ei,i=1,..., N>1. Chaque compartiment de dépôt est équipé de moyen de dépôt d'empilements de couches minces, tel que la pulvérisation cathodique assistée par champ magnétique.

Les compartiments de dépôt peuvent également comprendre des systèmes de pompage afin de créer les conditions de vide nécessaires au dépôt de l'empilement de couches minces.

Chaque compartiment de dépôt est généralement dédié au dépôt d'un ou plusieurs types de couches minces. Pour cela, chaque compartiment comprend une ou plusieurs cathodes, chacune cathode étant munie sur leur surface d'une couche de matière à déposer sur le substrat. Lors du dépôt, ces cathodes sont alimentées par une tension négative constante ou alternative, entre environ 200 et 1000 volts en valeur absolue, et la pulvérisation de la matière à déposer est réalisée lorsque le potentiel d'une cathode est négatif.

Les cathodes peuvent être fixes ou rotatives. Lorsqu'elles sont fixes, elles sont généralement planes et de forme rectangulaire, avec une largeur de 0,10 et 0,30 mètres et une longueur jusqu'à 4 mètres voire davantage. Un exemple de cathode plane est décrit dans US4166018A. Des exemples de cathodes rotatives sont décrites dans WO9634124A1 ou WO0238826A1

Le dépôt d'une couche mince se déroule généralement de la manière suivante.

Tout d'abord, un plasma froid est formé et maintenu dans un compartiment de la ligne à une pression typiquement comprise entre 10⁻¹ et 10⁻³ Torr (10 à 10⁻¹ Pa).

Ce plasma comprend généralement un mélange de gaz inerte, tel que l'argon, et de gaz réactif, tel que l'oxygène et/ou azote, notamment pour le dépôt d'oxydes et/ou nitrures et/ou oxynitrures.

Puis les ions du plasma sont accélérés vers les cathodes et pulvérisent les atomes de la couche de matière présente sur leur surface. Ces atomes se déposent ensuite sur le substrat. Au passage, ces atomes peuvent réagir avec le ou les gaz réactifs et/ou le substrat, avant de former la une couche mince sur le substrat.

Ces étapes sont généralement réalisées dans autant de compartiments que nécessaires pour former les différentes couches minces constituant l'empilement.

Afin d'obtenir un empilement de couches minces de qualité, c'est-à-dire un empilement dont les couches minces présentent une homogénéité, une pureté et une adhésion de surface suffisantes pour les applications recherchées, il est essentiel qu'un niveau de vide poussé, également appelé vide résiduel soit établi dans les compartiments de la ligne de dépôt avant la formation du plasma puis lors des dépôts. Le niveau de ce vide résiduel se situe entre 10⁻⁴ et 10⁻⁷ Torr (10⁻² à 10⁻⁵ Pa), plus souvent entre 10⁻⁵ et 10⁻⁶ Torr (10⁻³ à 10⁻⁴ Pa).

Il également nécessaire d'éviter les fuites (air, eau...) susceptibles provoquer une modification de la composition du plasma ou une introduction de matière polluante dans les couches pendant le dépôt.

Avant la formation du plasma, le niveau de vide résiduel fournit notamment une indication du niveau de substances polluantes (gaz résiduels, eau ou autres molécules absorbées sur les surfaces puis relâchée, fuites) dans les compartiments de la ligne de dépôt. Ces substances polluantes sont susceptibles de perturber le dépôt ou polluer l'empilement de couches minces.

Pour la mesure du vide poussé ou secondaire, il est courant d'utiliser plusieurs types de manomètres ou jauges à vide, seuls ou en combinaison, répartis le long de la ligne de dépôt.

A titre d'exemple illustratifs, en référence à la fig. 1, la ligne de dépôt 1000 peut comprendre plusieurs manomètres ou jauges 1008 à vide primaire et/ou secondaire répartis le long de ladite ligne de dépôts sur différents compartiments. Ces manomètres ou jauges 1008 sont généralement disposées sur le côté, au-dessous et/ou en-dessous des compartiments selon la configuration de la ligne de dépôt. Ils sont généralement situés à l'extérieur des compartiments et connectés aux compartiments à l'aide de connections pneumatiques. Ces connections pneumatiques permettent d'assurer une circulation de l'atmosphère des compartiments vers les manomètres ou jauges, et ainsi la mesure du niveau de vide dans les compartiments.

A titre d'exemples de manomètres ou jauges à vide secondaire, il peut être cité les manomètres à vide capacitifs à membranes déformables, les manomètres à vide thermique, tels que les manomètres à thermocouple ou les manomètres de Pirani, les manomètres à ionisation à cathode froide, tel que les manomètres à plasma simple de type manomètre de Penning décrit dans US2197079A, ou encore les manomètres à plasmas doubles comme celui décrit dans FR 1485659 B.

### Résumé de l'invention

### Problème technique

La pratique courante de répartir des manomètres ou jauges à vide le long de la ligne de dépôt présente plusieurs inconvénients.

Premièrement, la mesure du niveau vide est réalisée avec différentes manomètres ou jauges dont le nombre peut devenir très important lorsque la ligne dépôt comprend de nombreux compartiments. Cela peut engendrer un coût économique non négligeable tant lors de l'installation de la ligne de dépôts avec l'achat du matériel, qu'ensuite, lors de la maintenance, notamment lorsque les manomètres ou jauges doivent être remplacés et réparés. Il peut donc être avantageux d'en réduire le nombre.

Deuxièmement, il est fréquemment constaté que les manomètres et jauges actuels sont souvent peu précis. Les niveaux de vide qu'ils mesurent ne correspondent pas toujours précisément au niveau de vide réel dans les compartiments, et/ou que, pour un même niveau de vide, les niveaux de vide mesurés sont différents d'un manomètre ou d'une jauge à l'autre. Ce manque de précision a souvent pour origine une dérive dans le temps, dérive provoquée notamment par la pollution des manomètres par la matière des couches minces déposées. Cela est principalement dû au fait que les manomètres demeurent pendant tout leur cycle de vie. Les remplacer et/ou les nettoyer est une opération délicate et nécessite un arrêt de la production, qui engendre des pertes de production et des coûts supplémentaires.

Troisièmement, la calibration des manomètres ou jauges pour des niveaux de vide secondaire est opération longue et fastidieuse. Elle doit être régulièrement répétée afin d'assurer une mesure correcte du niveau de vide. La calibration nécessite des moyens supplémentaires à disposition sur site de production et/ou un renvoi auprès des fournisseurs, notamment pour nettoyage. Des coûts supplémentaires et des retards de production peuvent apparaître.

Quatrièmement, pour certains empilements, en particulier pour les empilements comprenant des couches minces très réactives, il peut avoir un besoin de contrôle précis du niveau de vide à proximité du substrat ou du lieu de formation du plasma, ou encore juste à la surface du substrat.

Or, dans les systèmes actuels de dépôt par pulvérisation cathodique magnétron, l'espace disponible dans les tunnels, notamment les conduits de passage entre les compartiments est très réduit. Il est généralement d'au plus 13 mm, voire d'au plus 11mm et parfois d'au plus 10mm. Il peut être encore plus réduit, par exemple entre 5 mm et 8 mm, pour les compartiments de dépôt d'empilements de couches minces sur substrat en verre. En outre, les champs électriques et magnétiques dans cet espace sont particulièrement intenses.

Les manomètres et jauges actuels, tels que celui connu dans FR 1485659, ont des encombrements géométriques, des contraintes quant à leur alimentation électrique et/ou des sensibilités aux champs électriques et/ou magnétiques qui les rendent inadaptées pour un positionnement à proximité du substrat et/ou du lieu de formation du plasma, encore en surface substrat entre les cathodes et support de substrat. A l'heure actuel, il est donc impossible d'obtenir une mesure précise et fiable du niveau vide dans ces positions pour le contrôle recherché.

Cinquièmement, il peut également avoir des besoins de contrôle de vide dans les différents compartiments de la ligne de dépôt, au plus près du substrat, notamment avant le démarrage des dépôts de couches, entre deux campagnes de dépôts et/ou au cours d'une campagne lorsque que des problèmes de qualité sont observés. Un tel contrôle permet par exemple de détecter d'éventuelles fuites de vide ou d'autres anomalie au niveau des cathodes.

### Solution au problème technique

Un premier aspect de l'invention concerne un système embarqué comprenant un manomètre à ionisation à cathode froide tel que décrit dans la revendication 1, les revendications dépendantes étant des modes avantageux de réalisation.

Plus précisément, il est décrit un manomètre à ionisation à cathode froide à plasmas doubles dont la géométrie compacte, permise entre autres par la forme particulière de ces électrodes et par les caractéristiques de ses aimants, permet une utilisation sous les cathodes d'une ligne de dépôt, ainsi une mesure du niveau de vide au plus près du substrat.

En particulier, le manomètre peut être intégré dans un système embarqué, en particulier dans un système embarqué autonome, de mesure de niveau de vide. Ce système embarqué permet une mesure de niveau de vide à proximité, en particulier au niveau de la surface du substrat, directement sous les cathodes de la ligne de dépôt de couches minces. Plus précisément, ce système peut être posé directement sur la surface du substrat et ainsi obtenir une mesure de niveau de vide juste au niveau de la surface du substrat.

Un deuxième aspect de l'invention concerne une méthode de contrôle du vide dans une ligne de dépôt de couches minces dans lequel un système embarqué est utilisé et telle que décrite dans la revendication 15.

### Avantages de l'invention

Un premier avantage de l'invention est que l'encombrement du manomètre pour le premier aspect de l'invention est réduit. Un tel manomètre compact permet une intégration plus facile dans un système embarqué pour une mesure de niveau de vide entre le substrat et les cathodes. En effet, le manomètre permet la fabrication de système embarqué de mesure de niveau de vide dont l'encombrement est compatible avec l'espace disponible, typiquement moins de 13 mm de hauteur, voire entre 12 mm et 10 mm, dans les tunnels de passage.

Un deuxième avantage est qu'il suffit d'un seul système embarqué selon le premier aspect de l'invention pour mesurer le niveau de vide le long de la ligne de dépôt. Lorsque le système embarqué est disposé sur la surface d'un substrat, il voyage avec celui-là dans la ligne de dépôt. Il est alors non seulement possible d'obtenir un profil précis du niveau de vide pour l'ensemble de la ligne de dépôt mais également pour chaque compartiment. Plusieurs systèmes embarqués peuvent être utilisés mais leur nombre peut rester avantageusement réduit, surtout lorsqu'un seul système est utilisé. Le coût économique à l'achat et en maintenance est considérablement moindre par rapport à une ligne de dépôt conventionnelle. De manière complémentaire ou alternative, le système embarqué peut être solution de remplacement pour certains manomètres stationnaires, c'est-à-dire disposés à demeure dans la ligne, lorsqu'ils sont défectueux. Il n'est alors plus nécessaire de remplacer, et un arrêt de la ligne est évité.

Un troisième avantage est que la dérive dans le temps du manomètre pour le premier aspect de l'invention est facilement contrôlable puisque que le système embarqué, voyageant avec le substrat, sort de la ligne de dépôt avec le substrat. Le manomètre est donc facilement accessible. Il n'est donc plus besoin de suspendre la production pour intervenir sur ce manomètre. Cette facilité d'accès permet des nettoyages plus réguliers et plus aisés et le besoin de calibration est moins fréquent.

Un quatrième avantage est que le manomètre et le système embarqué selon l'invention peuvent être utilisés à tout moment lors de la misé sous-vide, par exemple lors du pompage, ou de la production de l'empilement de couches minces, par exemple lors du dépôt, afin de procéder à des mesures et des vérifications du niveau de vide le long de la ligne de dépôt. En particulier, ils peuvent avantageusement servir à une mesure de niveau de vide avant le démarrage des dépôts de couches, entre deux campagnes de dépôts et/ou au cours d'une campagne lorsque que des problèmes de qualité sont observés.

Un cinquième avantage est que les manomètres du système embarqué sont portatifs et amovibles. Leur utilisation sur plusieurs lignes de dépôts d'empilements de couches minces est possible. Autrement dit, ils ne sont pas structurellement liés et/ou fixés à la ligne de dépôt dans laquelle ils sont utilisés, et peuvent très facilement être déplacés d'une ligne à l'autre selon les besoins de mesure et de contrôle. Il n'est donc plus nécessaire d'équiper les lignes de dépôt avec des instruments de mesure et de contrôle de vide dédiés.

### Brève description des dessins

[Fig. 1] est une représentation schématique d'une ligne de dépôt conventionnelle.
[Fig. 2] est une représentation orthographique d'un mode de réalisation d'un manomètre pour le premier aspect de l'invention.
[Fig. 3] est une vue de dessus du manomètre de la fig.2.
[Fig. 4] est une vue de face du manomètre de la fig. 2.
[Fig. 5] est une vue de côté du manomètre de la fig. 2.
[Fig. 6] représente l'évolution du courant mesuré en fonction de la pression pour un exemple de mode de réalisation d'un manomètre pour le premier aspect de l'invention.
[Fig. 7] est une représentation orthographique d'un mode de réalisation d'un système embarqué selon le premier aspect de l'invention.
[Fig. 8] est une vue de dessus du système de la fig.7.
[Fig. 9] est une vue de côté du système de la fig. 7.
[Fig. 10] est une représentation orthographique d'un exemple de disposition d'un système embarqué sur un substrat plan.
[Fig. 11] est une vue de côté de l'exemple de disposition d'un système embarqué sur un substrat plan de la fig. 10.
[Fig. 12] est un diagramme logique de flux physique d'un système embarqué selon un mode de réalisation.

### Description détaillée de modes de réalisation

Un mode de réalisation du nanomètre pour le premier aspect de l'invention est illustré sur les fig. 2 à 5. Le manomètre 2000 à ionisation à cathode froide comprend :
- au moins deux paires 2001, 2002 d'aimants 2001a, 2001b, 2002a, 2002b, de préférence circulaires ;
- une cathode plane 2003 formant une chambre cathodique 2004 de forme allongée sensiblement parallélépipédique et munie d'au moins une ouverture, de préférence une ouverture 2004a latérale
- une anode plane 2005 disposée dans la chambre cathodique, ladite anode comprenant aux moins deux ouvertures 2005a, 2005b, de préférence circulaires ;
dans lequel :
- les aimants 2001a, 2001b, 2002a, 2002b ont une aimantation d'au moins 795774 A/m et une température maximale de fonctionnement d'au moins 80°C ;
- l'anode 2003 et la cathode 2005 sont constituées d'un matériau conducteur non magnétique ;
- la cathode 2003 et l'anode 2005 sont disposées dans l'entrefer desdits paires d'aimants 2001a, 2001b, 2002a, 2002b et les ouvertures 2005a, 2005b de l'anode 2005 se trouvent respectivement entre lesdits paires d'aimants 2001, 2002 de sorte qu'un plasma peut être formé entre chaque paire d'aimants 2001, 2002, et
- les signes des pôles formés par chaque paire d'aimants 2001, 2002 sont tels que dans deux plasmas voisins, les champs magnétiques sont parallèles, de même intensité et de sens contraire.

L'ouverture 2004a de la chambre cathodique 2004 permet une communication avec l'atmosphère extérieur de la chambre cathodique 2004. Autrement dit, elle permet la circulation des atmosphères, et donc des échanges gazeux, entre l'intérieur de la chambre cathodique 2004 et l'atmosphère extérieure, c'est-à-dire, en particulier, l'atmosphère d'une ligne de dépôt ou encore, plus spécifiquement, l'atmosphère d'un compartiment de dépôt de la ligne.

L'ouverture 2004a de la chambre 2004 peut avoir toute forme adaptée, par exemple, sous forme d'orifices circulaires ou de fentes verticales et/ou horizontales. L'ouverture peut également être continue le long de la chambre cathodique.

De préférence, l'ouverture 2004a de la chambre cathodique 2004 est une ouverture latérale 2004, tel qu'illustrée sur les fig. 2 à 5. Une ouverture latérale 2004a est avantageuse en ce qu'elle est éloignée des aimants 2001a, 2001b, 2002a, 2002b et préserve l'intégrité de la partie de la chambre cathodique 2004 où sont placées les paires d'aimants 2001, 2002. Elle est également avantageuse en ce qu'elle facile l'intégration dans un système embarqué en ce qu'il peut être agencé de manière à fournir un bouclier de protection pour les paires d'aimants et ainsi les préserver de tout dommage.

Dans le mode de réalisation représenté sur les fig. 2 à 5, la cathode 2003 est un profilé à section U. Ce type de section est avantageux car elle permet d'avoir une ouverture latérale sur tout le long de la chambre.

Toutefois, tout autre type de profilé ou agencement de la cathode 2003 peut convenir tant qu'il est adapté pour former une chambre cathodique 2004 allongée sensiblement rectangulaire. A titre d'exemple alternatif, la cathode 2003 peut être un profilé à section rectangulaire muni d'au moins une ouverture 2004 ou d'une pluralité d'ouvertures sur au moins une de ses faces, de préférence sur une de ses faces latérales.

De préférence, la ou les ouvertures 2004a de la chambre cathodique 2004 peuvent être orientés vers le bas. Une telle configuration permet de limiter la pollution de la chambre cathodique 2004 en évitant que des corps étrangers et/ou la matière déposée des cathodes d'une ligne de dépôt d'empilements de couches minces ne pénètrent dans ladite chambre.

De préférence, les deux ouvertures 2005a, 2005b dans l'anode plane 2005 sont des ouvertures circulaires. Par rapport à d'autres formes, la forme circulaire permet avantageusement d'avoir des champs magnétiques homogènes entre les paires d'aimants 2001, 2002 au niveau de l'anode 2005 pour la formation et la stabilité des plasmas.

Toutefois, la forme des ouvertures 2005a, 2005b dans l'anode plane 2005 n'est pas limitative. Toute forme adaptée pour l'obtention de champs magnétiques homogènes au niveau de l'anode 2005 peut être utilisée.

Les aimants 2001a, 2001b, 2002a, 2002b ont une aimantation d'au moins 795774 A/m et une température maximale de fonctionnement d'au moins 80°C. Selon les besoins, le niveau d'aimantation et la température de fonctionnement peuvent être plus élevés. Selon certains modes de réalisation, les aimants 2001a, 2001b, 2002a, 2002b peuvent avoir une aimantation d'au moins 875352 A/m, voire d'au moins 954930 A/m afin d'avoir un champ magnétique plus intense dans les plasmas. Si le manomètre 2000 est destiné à être utilisé à des températures plus élevées, les températures de fonctionnement des aimants 2001a, 2001b, 2002a, 2002b peuvent d'être d'au moins 120°C, de préférence d'au moins 150°C, voire d'au moins 200°C.

De préférence, l'épaisseur des aimants 2001a, 2001b, 2002a, 2002b est d'au plus 2 mm, en particulier d'au plus 1 mm.

Des exemples d'aimants adaptés sont les aimants sont à base d'un alliage néodyme, en particulier à base d'un alliage néodyme-fer, de préférence à base d'un alliage néodyme-fer-bore.

Les aimants 2001a, 2001b, 2002a, 2002b peuvent être disposés à l'intérieur ou à l'extérieur de la chambre cathodique 2004. De préférence, comme illustré sur les fig. 2 à 4, les aimants sont fixés sur la cathode. Ils peuvent être fixés par tout moyen adapté, notamment par collage ou par un système de visserie ou de sertissage.

De préférence, les aimants 2001a, 2001b, 2002a, 2002b peuvent être fixés sans être contact avec la cathode 2003. Cette absence de contact direct avec la cathode 2003 permet d'éviter un échauffement, et donc une dégradation, des aimants 2001a, 2001b, 2002a, 200b lorsque que la cathode 2003 est susceptible de chauffer sous l'effet des plasmas du manomètre pendant son fonctionnement.

Dans un mode avantageux de réalisation, comme illustré sur les fig. 2 à 5, les aimants 2001a, 2001b, 2002a, 2002b sont fixés à l'extérieur de la chambre cathodique 2004. Les aimants 2001a, 2001b, 2002a, 2002b sont alors e isolés de l'atmosphère de la chambre cathodique 2004. Ils peuvent également être isolés l'atmosphère de la ligne de dépôt à l'aide de capots et/ou revêtements de protection (non représentés). Les possibles dégradations par les gaz utilisés lors du dépôt et/ou les matières déposées dans les couches minces sont alors limitées voire complètement éliminés.

Un autre avantage d'une fixation des aimants 2001a, 2001b, 2002a, 2002b à l'extérieure de la chambre cathodique 2004 est qu'ils sont facilement accessibles. Le remplacement ou le nettoyage de la cathode 2003 et/ou des aimants 2001a, 2001b, 2002a, 2002b sont plus faciles.

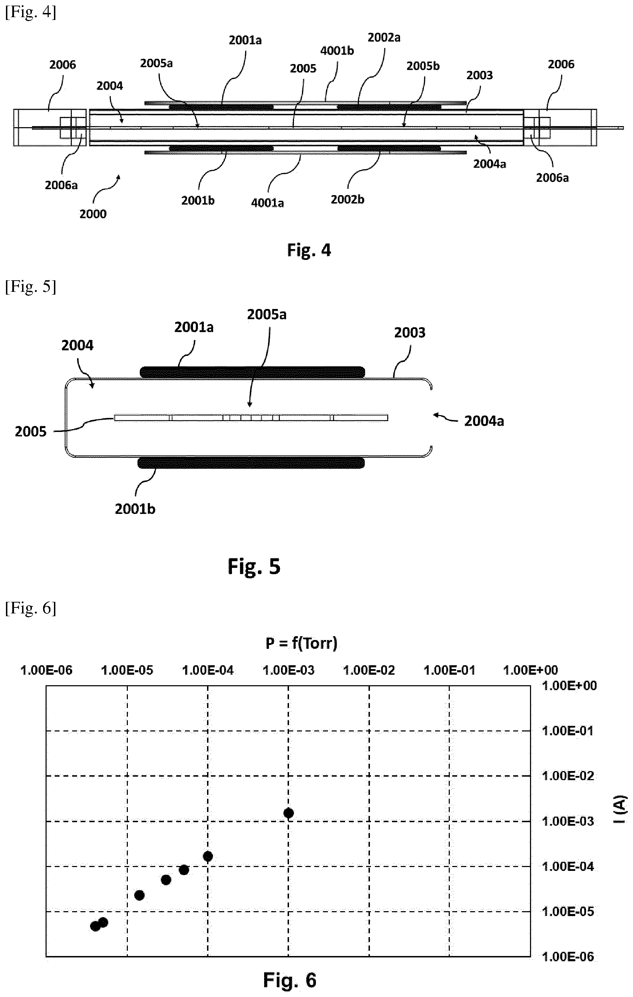

Le manomètre 2000 peut également comprendre des moyens 4001a, 4001b de couplage magnétique disposés sur les aimants d'un côté et de l'autre, dont des exemples sont représentés sur la fig. 4. Ces moyens 4001a, 4001b de couplage sont particulièrement avantageux en ce qu'ils peuvent assurer le confinement des champs magnétiques des aimants dans le manomètre, servir de support aux aimants et servir de bouclier magnétique afin de réduire les interactions avec les champs magnétiques extérieurs, c'est-à-dire les champs magnétiques de la ligne de dépôt, ainsi qu'avec les objets ferromagnétiques présents dans la ligne de dépôt. Les moyens de couplage permettent ainsi de réduire l'influence des champs magnétiques extérieurs sur la mesure du niveau de vide par le manomètre. Ces moyens de couplage peuvent être des plaques ferromagnétiques, par exemple des plaques en acier ferromagnétique.

Dans un autre mode de réalisation, les aimants 2001a, 2001b, 2002a, 2002b sont fixés à l'intérieur de la chambre cathodique 2004.

Selon certaines applications, s'il y a un risque de dégradation des aimants 2001a, 2001b, 2002a, 2002b par les gaz utilisés ou par un échauffement de la cathode lors du dépôt et/ou les matières déposées dans les couches minces, il peut être avantageux de les revêtir d'un revêtement protecteur, par exemple une résine ou un film polymère.

De préférence, les aimants 2001a, 2001b, 2002a, 2002b ont une taille plus importante que celle des ouvertures 2005a, 2005b de l'anode plane 2005. Cela permet d'assurer un champ magnétique homogène dans les plasmas.

Les électrodes, c'est-à-dire la cathode 2003 et l'anode 2005, sont constitués d'un matériau conducteur non magnétique, par exemple l'aluminium et ses alliages le cuivre et ses alliages ou encore l'acier inoxydable non magnétique. L'aluminium est avantageux en ce qu'il s'agit d'un métal très léger et bon marché. L'acier inoxydable non magnétique est également avantageux car il est bon marché et mécaniquement très résistant.

Comme illustré sur les fig. 2 à 5, le manomètre 2000 peut également comprendre des isolants électriques 2006 disposé entre la cathode 2003 et l'anode 2005, et situés à leur périphérie, en particulier sur le côté de la chambre cathodique.

Ces isolants électriques 2006 peuvent avantageusement comprendre des évidements 2006a dans leur partie la plus proche de la chambre cathodique 2004. Ces évidements permettent de réduire le risque de court-circuit en cas de pollution de l'espace de jonction entre lesdits isolants 2006 et la chambre cathode 2004 par de la matière conductrice provenant des dépôts. Ils permettent également de réduire l'exposition des isolants des plasmas formés dans la chambre cathodique 2004 pendant le fonctionnement du manomètre 2000.

Dans des modes préférés de réalisation, combinables entre eux et permettant notamment de réduire considérablement l'encombrement géométrique du manomètre 2000, c'est-à-dire d'obtenir un manomètre 2000 particulièrement compact :
- l'épaisseur de la cathode 2003 peut être d'au plus 2 mm, en particulier d'au plus 1mm, de préférence d'environ 0,2 mm ;
- l'épaisseur de l'anode 2005 peut être comprise entre 0,1 mm et 2 mm, de préférence 0,5 mm ;
- l'espacement entre les aimants de chaque paire 2001, 2002 d'aimants 2001a, 2001b, 2002a, 2002b peut être compris entre 5 mm et 10 mm, de préférence entre 5 mm et 8 mm, et particulièrement de 7 mm ;
- les aimants 2001a, 2001b, 2002a, 2002b et les ouvertures 2005a, 2005b de l'anode 2005 sont circulaires, le diamètre desdites ouvertures 2005a, 2005b de l'anode 2005 est compris entre 10 et 20mm, en particulier entre 14mm et 19mm, et le diamètre des aimants 2001a, 2001b, 2002a, 2002b est compris entre 14 et 30, de préférence entre 15 et 20mm ;
- les aimants 2001a, 2001b, 2002a, 2002b sont fixés sur la cathode 2003 à l'intérieur ou à l'extérieur de chambre cathodique 2004.

L'épaisseur totale du manomètre 2000 peut être alors d'au plus 12 mm, en particulier d'au plus 11 mm, de préférence d'au plus 10 mm, pour une longueur totale, non limitative, du manomètre de quelques dizaines de centimètre, voire de moins de 100mm, de préférence d'au plus 60 mm, voire d'au plus 40mm, voire 30mm dans les formats les plus compacts.

Tous les modes de réalisation décrits sont combinables entre eux à moins qu'ils n'apparaissent techniquement incompatibles.

Le manomètre 2000 pour le premier aspect de l'invention fonctionne de la manière suivante. Une tension électrique comprise entre 2 kV et 3 kV est appliquée entre la cathode 2003 et l'anode 2005 afin de créer des plasmas dans la chambre cathodique 2004 localisés dans les ouvertures 2005a et 2005b de l'anode 2005. Puis le courant électrique de ce plasma est mesuré. Le courant électrique varie avec la pression de l'atmosphère de la chambre cathodique 2004, typiquement la courant varie entre 1 mA et de 1 µA pour une pression variant entre environ 10⁻³ Torr et 10⁻⁶ Torr.

En raison de la très grande sensibilité du manomètre selon l'invention, il convient d'éviter l'apparition de courants électriques élevés afin d'en assurer le bon fonctionnement et d'éviter sa détérioration. Aussi, lorsque la pression devient trop élevée, c'est-à-dire largement supérieur à 10⁻³ Torr, il est préférable de le désactiver.

Dans un exemple de mode de réalisation d'un manomètre pour le premier aspect de l'invention, le manomètre 2000 a une configuration telle qu'illustrée sur les figures 2 à 5 avec les caractéristiques décrites dans le tableau 1.

| Tableau 1 | |
|---|---|
| Matériau de l'anode | Inox |
| Epaisseur anode | 0,5mm |
| Matériau de la cathode | Acier inox non magnétique |
| Epaisseur cathode | 0,2mm |
| Diamètre des ouvertures circulaires dans l'anode | 18mm |
| Diamètre des aimants circulaires | 20mm |
| Epaisseur des | |
| Type d'aimant | NdFeB N45 |
| Epaisseur totale du manomètre | 10mm |
| Tension de fonctionnent | 2.5kV |

La variation du courant mesuré à l'anode 2005 du manomètre 2000 selon l'exemple en fonction de la pression est illustrée sur la fig. 6. Le courant varie quasi linéairement en échelle logarithmique entre 10⁻⁶ A et 10⁻² A lorsque la pression varie entre 10⁻⁶ Torr et 10⁻³ Torr.

Un manomètre 2000 à vide pour le premier aspect de l'invention peut être avantageusement intégré dans un système embarqué, éventuellement autonome, pour la mesure de vide dans une ligne de dépôt d'empilement de couches minces.

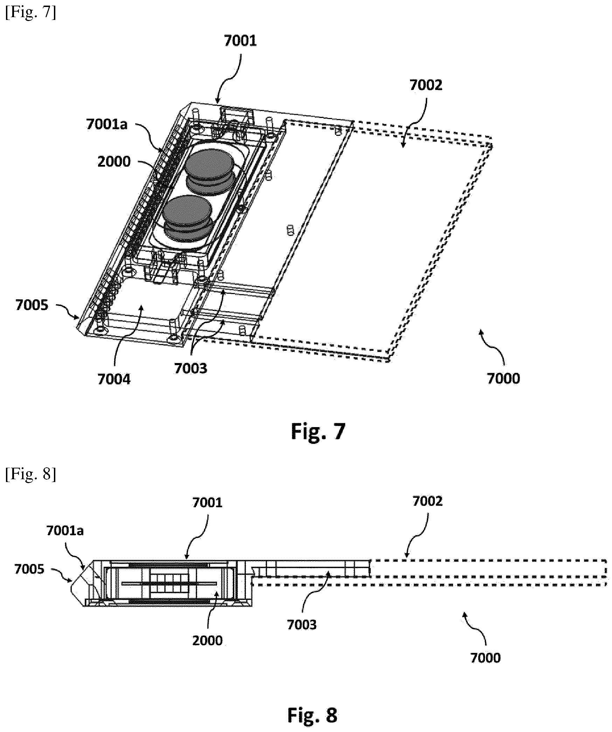

Un mode de réalisation du premier aspect de l'invention est illustré sur les fig. 7 à 11, qui ne sont pas à l'échelle. Le système embarqué 7000 de mesure de vide comprend :
- un premier compartiment 7001 dans lequel est logé un manomètre pour le premier aspect de l'invention, notamment selon l'un des quelconques modes de réalisation décrits précédemment, et comprenant au moins une ouverture 7001a permettant à l'atmosphère extérieur d'entrer en contact avec ledit manomètre ;
- un deuxième compartiment 7002 (représenté par des tirets sur la figure) comprenant une source autonome d'alimentation électrique (non représenté), un dispositif électronique de contrôle (non représenté), ainsi qu'un support de stockage électronique (non représenté) et/ou un dispositif de télécommunication (non représenté) ;
dans lequel système :
- le premier compartiment 7001 et le deuxième compartiment 7002 sont configurés l'un par rapport à l'autre de sorte que, lorsque le système embarqué 7000 est disposé sur un substrat plan 10000, en particulier sur le rebord périphérique dudit substrat plan 10000, l'épaisseur, E, du système embarqué 7000 est constante par rapport à une surface 10001 dudit substrat plan 10000 sur laquelle il disposé.

La ou les ouvertures 7001a du premier compartiment 7001 permet à l'atmosphère extérieur d'entrer en contact avec le manomètre 2000pour le premier aspect de l'invention. Cette ouverture 7001a peut être de toute forme adaptée. Elle peut être une simple ouverture longitudinale ou être une pluralité d'ouvertures, notamment circulaires, comme illustré sur les figures. Ce ou ces ouvertures 7001a peuvent être des ouvertures débouchant sur la face supérieure, inférieure et/ou latérale du premier compartiment 7001.

L'ouverture 7001a a pour fonction première d'assurer une circulation et un échange efficaces entre l'atmosphère de la chambre cathodique 2004 du manomètre 2000 et l'atmosphère des compartiments de la ligne de dépôt.

De préférence, la ou les ouvertures 7001a sont en outre disposés de sorte à limiter la pollution premier compartiment 7001 en évitant que des corps étrangers et/ou la matière déposée des cathodes d'une ligne de dépôt d'empilements de couches minces ne pénètrent dans la chambre cathodique 2004.

Selon un mode de réalisation avantageux, comme illustré sur les fig. 7 à 11, cette ou ces ouvertures 7001a peuvent former des canaux comprenant une conduite principale oblique débouchant sur la face latérale du premier compartiment 7001 et l'intérieur dudit premier compartiment 7001, et une conduite secondaire rectiligne débouchant sur la face inférieure du premier compartiment 7001 et dans la conduite principale oblique. Une telle configuration est avantageuse en ce qu'elle assure une meilleure circulation entre l'atmosphère de la chambre cathodique 2004 du manomètre 200 et l'atmosphère de la ligne de dépôt et en ce que, dans l'éventualité où un débris s'introduirait dans l'ouverture via la conduite principale, ce débris serait évacué via la conduite secondaire.

Dans une variante de ce mode de réalisation, la ou les ouvertures 7001a sont telles qu'elles ne débouchent pas sur la partie supérieure du compartiment 7001. Le manomètre 2000 est ainsi protégé de la matière déposée lors du dépôt de couches minces. Par exemple, la ou les ouvertures 7001a peuvent être obstruées sur la partie supérieure du compartiment 7001.

Le deuxième compartiment 7002 comprend les dispositifs nécessaires au fonctionnement d'un manomètre 2000 pour le premier aspect de l'invention, notamment l'alimentation électrique, et à l'acquisition des données, en particulier la mesure du courant sur l'anode 2005 du manomètre 2000 avec éventuellement la conversion de cette mesure en valeurs de pression.

Afin de permettre le passage des fils électriques et autres connectiques entre le premier compartiment 7001 et le deuxième compartiment 7002, un moyen de communication 7003, par exemple sous la forme d'un fourreau passe-fils, peut être prévu entre les deux compartiments 7001, 7002., via éventuellement un compartiment annexe 7004, qui peut également comprendre une ou des ouvertures latérales.

La source autonome peut être une batterie rechargeable, de préférence plate, par exemple une batterie Li-ion, Li-polymère, ou des piles électriques compactes. La puissance et capacité de la batterie doivent être suffisantes pour l'alimentation en tension de la cathode 2003 du manomètre 2000, éventuellement via un transformateur adapté, et l'alimentation électrique du dispositif électronique de contrôle.

Le dispositif de contrôle électronique peut être un circuit intégré programmable, par exemple une carte FPGA, un micro-ordinateur monocarte ou une carte électronique avec un microcontrôleur programmable.

La récupération des données du manomètre, en particulier les mesures de courant sur l'anode 2005 et/ou les valeurs de pression après conversion par le dispositif électronique de contrôle lors de l'utilisation du système embarqué 7000, peut être réalisée de plusieurs manières.

Selon une première manière, les données peuvent être stockées sur support électronique de stockage, par exemple une carte à mémoire flash, tel qu'une carte SD. Une fois l'acquisition terminée et les données enregistrées sur le support électronique de stockage, ce support peut être lu sur tout dispositif électronique approprié pour récupérer les données et d'en réaliser un éventuel traitement numérique ultérieur. Le support de stockage est de préférence amovible afin d'en faciliter le remplacement. Il peut également être non amovible. Dans ce cas, il convient de prévoir un moyen de lecture par connexion directe, tel qu'un port physique de connexion, par exemple de type USB, ou indirecte par un signal électromagnétique.

Selon une deuxième manière, les données peuvent être transmises via un dispositif de télécommunication, notamment par à l'aide de tout signal radio adapté, tel que Wifi ou Bluetooth. De préférence, la transmission peut être réalisée en temps réel, notamment à haut débit afin de pouvoir suivre les mesures en temps réel lors de l'utilisation du système embarqué dans une ligne de dépôt.

Selon une troisième manière, la première et la deuxième manière peuvent être combinées. Cela peut être avantageux pour assurer une sauvegarde des données en cas de défaillance du dispositif de télécommunication ou une rupture éventuelle de télécommunication, par exemple lorsque le système embarqué traverse certaines zones de la ligne de dépôt susceptibles de bloquer les ondes radio.

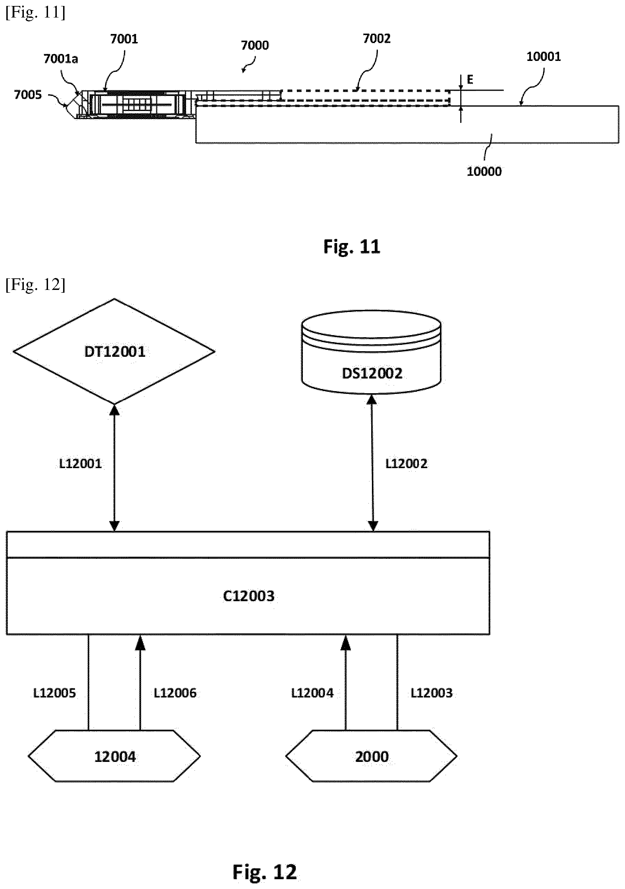

Un exemple de diagramme logique de flux physique d'un mode de réalisation d'un système embarqué selon le premier aspect de l'invention est représenté sur la fig. 12.

Dans un mode de réalisation, un dispositif électronique C12003 de contrôle alimenté par une source autonome d'alimentation électrique (non représentée) fournit et contrôle L12003 l'alimentation électrique nécessaire au fonctionnement d'un manomètre 2000 pour le premier aspect de l'invention. En particulier, le dispositif électronique C12003 de contrôle régule la tension électrique appliquée à la cathode 2003 du manomètre 2000. Simultanément, il mesure L12004 le courant à l'anode 2004 du manomètre, puis éventuellement il convertit la valeur du courant en une valeur de pression.

Le dispositif électronique C12003 comprend une interface L12002 d'entrée/sortie pour l'écriture des données de mesure dans un support DS12002 de stockage, de préférence un support de stockage à haute fréquence. Le support de stockage est de présence un support de stockage non-volatile lorsque les données sont destinées à être récupérées après les mesures.

Dans un autre mode de réalisation, le dispositif électronique C12003 de contrôle peut en coutre comprendre une interface L12001 d'entrée/sortie pour le transfert de données de mesure à l'extérieure par l'intermédiaire d'un dispositif DT120001 de télécommunication ou d'un concentrateur USB. Dans le cas d'un dispositif de télécommunication, celui-là convertit le signal électrique provenant du dispositif électronique C12003 de contrôle et correspondant aux données de mesure en un signal électromagnétique émis et destiné à être reçu par un récepteur extérieur (non représenté).

Dans ce mode de réalisation, le support DS12002 de stockage est facultatif. L'utilisation d'un support DS12002 reste cependant avantageux en ce qu'il peut constituer une sauvegarde des données de mesure, il sera alors non volatile, ou une mémoire tampon pour le stockage temporaire des données avant leur transmission à l'extérieur via le dispositif DT12001 de télécommunication, il peut alors être un support de stockage volatile.

Dans un autre mode de réalisation combinable avec les autres précédemment décrits, et conformément à certains modes de réalisation du système embarqué 7000 selon le premier aspect de l'invention et décrits ci-après, le dispositif électronique C12003 de contrôle fournit et contrôle L12005 l'alimentation électrique nécessaire au fonctionnement d'un manomètre 12004 à vide primaire. Simultanément, il acquiert L12006 le signal électrique de sortie du manomètre 12004 à vide primaire, puis éventuellement il la convertit en une valeur de pression.

Dans un mode particulier de réalisation, le système embarqué peut comprendre en outre au moins un manomètre à vide primaire (non représenté) disposé dans le premier 7001 ou dans un autre compartiment adjacent au premier compartiment 7001. Par exemple, un espace supplémentaire 7004 peut être prévu dans le premier compartiment 7001 pour permettre de loger un tel nanomètre. L'espace supplémentaire 7004 peut alors comprendre des ouvertures latérales comme le premier compartiment 7001.

Un manomètre à vide primaire peut être un complément avantageux lorsque le niveau de vide n'est plus ou ne devient plus mesurable, par exemple en cas de mesure lors des dépôts de couche ou en cas de fuite importante, par le manomètre à vide 2000 pour le premier aspect de l'invention. En particulier, il est possible de mesurer un plus grand intervalle de niveaux de vide dans la ligne de dépôt.

Des exemples de manomètre à vide primaire sont les manomètres de Pirani permettant de mesurer des niveaux de vide entre 1 et 10⁻⁷ bar. Plusieurs manomètres à vide primaire permettant de mesurer des intervalles différents de niveaux de vide peuvent être combinées. Par exemple, il est possible de combiner un premier manomètre à vide primaire permettant de mesurer des niveaux de vide entre 10⁻² bar et 10⁻⁷ bar, et un deuxième permettant de mesurer des niveaux de vide entre 10⁻¹ et 10⁻⁵ bar pour couvrir l'ensemble de l'intervalle 10⁻¹ et 10⁻⁷ bar.

Le premier compartiment 7001 et le deuxième compartiment 7002 du système embarqué 7000 sont de préférence disposés l'un par rapport à l'autre de manière à minimiser l'épaisseur globale du système embarqué 7000 afin qu'il puisse être placé dans l'espace réduit entre le substrat plan et les cathodes de la ligne de dépôt.

Dans un mode avantageux de réalisation, tel que celui illustré sur les fig. 7 à 11, le deuxième compartiment 7002 peut être disposé dans le prolongement du premier compartiment 7001 de sorte que, lorsque le système embarqué 7000 est disposé sur la surface 10001 d'un substrat plan 10000, notamment au niveau du rebord périphérique d'un substrat plan 10000, une partie premier compartiment 7001 est en dehors de ladite surface 10001 dudit substrat plan 10000.

Ce mode de réalisation est particulièrement avantageux en ce qu'il permet de profiter de l'épaisseur du substrat plan 10000, en particulier d'un substrat plan verrier, afin de compenser une épaisseur du premier compartiment 7001 éventuellement plus importante que celle du deuxième compartiment 7002. Une épaisseur plus importante du premier compartiment 7001 peut être due au manomètre 2000 à vide pour le premier aspect de l'invention dont l'épaisseur, dans certains modes de réalisation, ne peut être suffisamment réduite par rapport aux dispositifs et systèmes électroniques contenus dans le deuxième compartiment 7002.

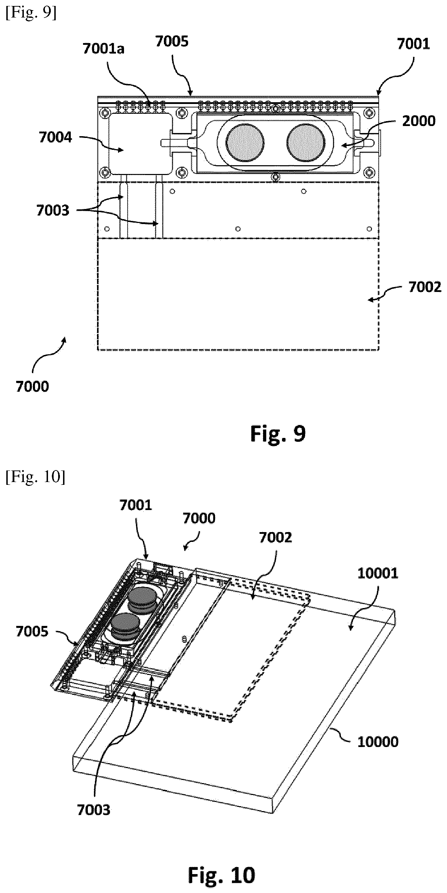

Un exemple de disposition d'un système embarqué 7000 sur un substrat plan 10000 est représenté schématiquement sur les figures 10 et 11.

De préférence, le dépassement du système embarqué par rapport au bord du substrat plan est limité. En pratique, il est préférable que le dépassement soit limité à 6 cm au plus, voire 5 cm au plus, en particulier pour les substrats plans verriers.

De préférence, la distance entre la face inférieure du substrat plan 10000, c'est-à-dire la face opposée à celle sur laquelle est disposé le système embarqué 7000, et la face inférieure de la partie dudit système 7000 qui dépasse du substrat plan est d'environ 0,5mm. C'est le cas, par exemple, d'un système embarqué 7000 d'une épaisseur de 6,5mm pour un substrat d'une épaisseur de 4 mm.

Le système embarqué 7000 peut être fixé sur la surface du substrat plan 10000 à l'aide de tout moyen adapté, par exemple à l'aide d'un adhésif ou d'une colle. Il peut également être posé sur la surface sans moyen de fixation.

Dans un mode de réalisation, le système embarqué 7000 peut comprendre, en outre, sur sa partie avant, un moyen de désencombrement 7005, de préférence sous la forme d'un chanfrein supérieur dont un exemple est représenté sur les fig. 7 à 11. Le moyen de désencombrement 7005 est situé sur la partie avant du système embarqué 7000, c'est-à-dire sur la partie du système qui entre ou est introduit en premier dans la ligne de dépôt lorsque le système embarqué 7000 est disposé sur le substrat plan.

Ce moyen de désencombrement 7005 a pour fonction avantageuse de repousser tout de débris ou d'obstacles, tels que fils, caches, débris de verre et/ou de cathodes, susceptibles de tomber et/ou de se retrouver devant le système embarqué et gêner son déplacement avec le substrat plan 10000. Autrement dit, le moyen de désencombrement facilite l'introduction et le déplacement du système embarqué dans la ligne de dépôt.

Dans des modes avantageux de réalisation du système embarqué 7000 selon le premier aspect de l'invention, le système 7000 peut comprendre d'autres capteurs et/ou dispositifs supplémentaires disposés dans un même ou différents compartiments. Ces capteurs et/ou dispositifs peuvent avantageusement apporter des fonctions complémentaires au système embarqué. Par exemple, ils peuvent être des accéléromètres, des gaussmètres pour des mesures in-situ d'inspection de la puissance des aimants de la ligne de dépôt, des microbalances à quartz pour des mesures et/ou contrôle in-situ de l'épaisseur des couches déposées, des caméras vidéos, en particulier des caméras infrarouges, pour l'inspection visuelle des cathodes ou des compartiments, ou encore des modules de localisation spatiale, par exemple des modules GPS, pour permettre de corréler les mesures avec la position du système embarqué.

Tous les modes de réalisation décrits sont combinables entre eux à moins qu'ils n'apparaissent techniquement incompatibles.

Le système embarqué 7000 selon le premier aspect de l'invention peut être avantageusement mis en œuvre dans une méthode de diagnostic du niveau de vide d'une ligne de dépôt d'empilements de couches minces.

En ce sens, le deuxième aspect de l'invention concerne une méthode de diagnostic de vide dans une ligne de dépôt d'empilements de couches minces sur substrat plan, ladite méthode comprenant les étapes suivantes
- la disposition sur la surface 10001 d'au moins un substrat plan 10000 d'au moins un système embarqué 7000 selon le premier aspect de l'invention, notamment selon l'un des quelconques modes de réalisation décrits précédemment ;
- le déplacement du substrat plan 10000 dans tout ou partie de la ligne de dépôt ;
- la mesure du niveau de vide par le système embarqué 7000 lorsque le substrat plan 10000 se déplace.

Une telle méthode peut être utile pour la recherche de fuite de vide et/ou la diagnostique du niveau de vide à proximité du substrat avant, pendant et après le dépôt des empilements de couches minces.

La méthode permet de faire une mesure du niveau de vide tout le long de la ligne de dépôt, notamment dans chacun des compartiments de la ligne juste au niveau de la surface du substrat. Elle permet avantageusement une cartographie précise du niveau de vide dans la ligne de dépôt.

Il est également possible, grâce à la méthode, de réaliser des contrôles ciblés de certaines régions de la ligne dépôt.

Dans des modes avantageux de réalisation de la méthode, plusieurs systèmes embarqués disposés sur la surface d'un et/ou plusieurs substrats plans. Cela permet de construire un réseau de systèmes embarqués permettant une mesure du niveau sur toute la largeur et/ou toute la longueur du substrat plan. Il est alors possible de construire une cartographie précise en temps réel du niveau dans l'ensemble de la ligne de dépôt.

## Revendications

1. Système embarqué (7000) de mesure de vide **caractérisé en ce qu'**il comprend :
- un premier compartiment (7001) dans lequel est logé un manomètre (2000) à ionisation à cathode froide comprenant :
- au moins deux paires (2001, 2002) d'aimants (2001a, 2001b, 2002a, 2002b), de préférence circulaires ;
- une cathode plane (2003) formant une chambre cathodique (2004) de forme allongée sensiblement parallélépipédique et munie d'au moins une ouverture, de préférence une ouverture (2004a) latérale
- une anode plane (2005) disposée dans la chambre cathodique, ladite anode comprenant aux moins deux ouvertures (2005a, 2005b), de préférence circulaires ;
et dans lequel :
- les aimants (2001a, 2001b, 2002a, 2002b) ont une aimantation d'au moins 795774 A/m et une température maximale de fonctionnement d'au moins 80°C ;
- l'anode (2003) et la cathode (2005) sont constituées d'un matériau conducteur non magnétique ;
- la cathode (2003) et l'anode (2005) sont disposées dans l'entrefer desdits paires d'aimants (2001a, 2001b, 2002a, 2002b) et les ouvertures (2005a, 2005b) de l'anode (2005) se trouvent respectivement entre lesdits paires d'aimants (2001, 2002) de sorte qu'un plasma peut être formé entre chaque paire d'aimants (2001, 2002), et
- les signes des pôles formés par chaque paire d'aimants (2001, 2002) sont tels que dans deux plasmas voisins, les champs magnétiques sont parallèles, de même intensité et de sens contraire,
ledit premier compartiment (7001) comprenant au moins une ouverture (7001a) permettant à l'atmosphère extérieur d'entrer en contact avec ledit manomètre ;
- un deuxième compartiment (7002) comprenant une source autonome d'alimentation électrique, un dispositif électronique de contrôle, ainsi qu'un support de stockage électronique et/ou un dispositif de télécommunication;
et dans lequel :
- le premier compartiment (7001) et le deuxième compartiment (7002) sont configurés l'un par rapport à l'autre de sorte que, lorsque le système embarqué (7000) est disposé sur un substrat plan (10000), en particulier sur le rebord périphérique dudit substrat plan (10000), l'épaisseur, E, du système embarqué (7000) est constante par rapport à une surface (10001) dudit substrat plan (10000) sur laquelle il est disposé.

2. Système (7000) selon la revendication 1, tel que les aimants (2001a, 2001b, 2002a, 2002b) ont une aimantation d'au moins875352 A/m, voire d'au moins 954930 A/m.

3. Système (7000)) selon l'une des revendications 1 à 2, tel que la température maximale de fonctionnement des aimants (2001a, 2001b, 2002a, 2002b) est d'au moins 120°C, de préférence d'au moins 150°C, voire d'au moins 200°C.

4. Système (7000) selon l'une des revendications 1 à 3, tel que les aimants (2001a, 2001b, 2002a, 2002b) sont à base d'un alliage néodyme, en particulier à base d'un alliage néodyme-fer, de préférence à base d'un alliage néodyme-fer-bore.

5. Système (7000) selon l'une des revendications 1 à 4, tel que les aimants (2001a, 2001b, 2002a, 2002b) sont fixés sur la cathode (2003) à l'intérieur ou à l'extérieur de la chambre cathodique (2004).

6. Système (7000) selon l'une des revendications 1 à 5, tel que l'épaisseur de la cathode (2003) est d'au plus 2 mm, en particulier d'au plus 1mm, de préférence d'environ 0,2 mm.

7. Système (7000) selon l'une des revendications 1 à 6, tel que l'épaisseur de l'anode (2004) est comprise entre 0,1 mm et 2 mm, de préférence 0,5 mm.

8. Système (7000) selon l'une des revendications 1 à 7, tel que l'espacement entre les aimants de chaque paire (2001, 2002) d'aimants (2001a, 2001b, 2002a, 2002b) est compris entre 5 mm et 10 mm, de préférence entre 5 mm et 8 mm.

9. Système (7000) selon l'une de revendications 1 à 8, tel que l'épaisseur totale du manomètre (2000) est d'au plus 12mm, en particulier d'au plus 11mm, de préférence d'au plus 10mm.

10. Système (7000) selon l'une des revendications 1 à 9, tel que les aimants (2001a, 2001b, 2002a, 2002b) et les ouvertures (2005a, 2005b) de l'anode (2005) sont circulaires, le diamètre desdites ouvertures (2005a, 2005b) de l'anode (2005) est compris entre 10 et 20mm, en particulier entre 14mm et 19mm, et le diamètre des aimants (2001a, 2001b, 2002a, 2002b) est compris entre 14 et 30 mm.

11. Système (7000) selon l'une des revendications 1 à 10, tel que la cathode (2003) est un profilé à section en U ou un profilé à section rectangulaire muni d'au moins une ouverture (2004) sur au moins l'une de ses faces, de préférence l'une de ses faces latérales.

12. Système (7000) selon l'une des revendications 1 à 11, tel qu'il comprend en outre au moins un manomètre à vide primaire disposé dans le premier compartiment (7001) ou dans un autre compartiment adjacent au premier compartiment (7001).

13. Système (7000) selon l'une des revendications 1 à 12, tel que le deuxième compartiment (7002) peut être disposé dans le prolongement du premier compartiment (7001) de sorte que, lorsque le système embarqué (7000) est disposé sur la surface (10001) d'un substrat plan (10000), notamment au niveau du rebord périphérique d'un substrat plan (10000), une partie du premier compartiment (7001) est en dehors de ladite surface 10001 dudit substrat plan (10000).

14. Système (7000) selon l'une des revendications 1 à 13, tel qu'il comprend, en outre, sur sa partie avant, un moyen de désencombrement (70005), de préférence sous la forme d'un chanfrein supérieur.

15. Méthode de diagnostic de vide secondaire dans une ligne de dépôt d'empilements de couches minces sur substrat plan, ladite méthode comprenant les étapes suivantes :
- la disposition sur une surface (10001) d'au moins un substrat plan (10000) d'au moins un système embarqué (7000) selon l'une quelconque des revendications 1 à 14 ;
- le déplacement du substrat plan (10000) dans tout ou partie de la ligne de dépôt ;
- la mesure du niveau de vide secondaire par le système embarqué (7000) lorsque le substrat plan (10000) se déplace.

## Patentansprüche

1. Eingebettetes Vakuummesssystem (7000),
**dadurch gekennzeichnet, dass** es Folgendes umfasst:
- ein erstes Fach (7001), in dem ein Kaltkathoden-Ionisationsdruckmessgerät (2000) untergebracht ist, das Folgendes umfasst:
- mindestens zwei Paare (2001, 2002) von vorzugsweise kreisförmigen Magneten (2001a, 2001b, 2002a, 2002b);
- eine flache Kathode (2003), die eine Kathodenkammer (2004) mit länglicher, im Wesentlichen parallelepipedischer Form bildet und mit mindestens einer Öffnung, vorzugsweise einer seitlichen Öffnung (2004a), versehen ist;
- eine in der Kathodenkammer angeordnete flache Anode (2005), wobei die Anode mindestens zwei, vorzugsweise kreisförmige, Öffnungen (2005a, 2005b) umfasst;
und wobei:
- die Magnete (2001a, 2001b, 2002a, 2002b) eine Magnetisierung von mindestens 795774 A/m und eine maximale Betriebstemperatur von mindestens 80 °C aufweisen;
- die Anode (2003) und die Kathode (2005) aus einem nichtmagnetischen leitfähigen Material bestehen;
- die Kathode (2003) und die Anode (2005) im Luftspalt der Magnetpaare (2001a, 2001b, 2002a, 2002b) angeordnet sind und die Öffnungen (2005a, 2005b) der Anode (2005) sich jeweils zwischen den Magnetpaaren (2001, 2002) befinden, sodass zwischen jedem Magnetpaar (2001, 2002) ein Plasma gebildet werden kann, und
- die von jedem Magnetpaar (2001, 2002) gebildeten Pole Vorzeichen aufweisen derart, dass in zwei benachbarten Plasmen die Magnetfelder parallel, von gleicher Intensität sind und in entgegengesetzter Richtung verlaufen,
wobei das erste Fach (7001) mindestens eine Öffnung (7001a) umfasst, die es ermöglicht, dass die Außenatmosphäre mit dem Druckmessgerät in Kontakt kommt;
- ein zweites Fach (7002), das eine autonome Stromversorgungsquelle, ein elektronisches Steuergerät sowie ein elektronisches Speichermedium und/oder ein Telekommunikationsgerät umfasst;
und wobei:
- das erste Fach (7001) und das zweite Fach (7002) relativ zueinander so konfiguriert sind, dass, wenn das eingebettete System (7000) auf einem flachen Substrat (10000) angeordnet ist, insbesondere auf der Umfangskante des flachen Substrats (10000), die Dicke E des eingebetteten Systems (7000) relativ zu einer Oberfläche (10001) des flachen Substrats (10000), auf der es angeordnet ist, konstant ist.

2. System (7000) nach Anspruch 1, derart, dass die Magnete (2001a, 2001b, 2002a, 2002b) eine Magnetisierung von mindestens 875352 A/m oder sogar mindestens 954930 A/m aufweisen.

3. System (7000) nach einem der Ansprüche 1 bis 2, derart, dass die maximale Betriebstemperatur der Magnete (2001a, 2001b, 2002a, 2002b) mindestens 120 °C, vorzugsweise mindestens 150 °C oder sogar mindestens 200 °C beträgt.

4. System (7000) nach einem der Ansprüche 1 bis 3, derart, dass die Magnete (2001a, 2001b, 2002a, 2002b) auf einer Neodym-Legierung, insbesondere auf einer Neodym-Eisen-Legierung, vorzugsweise auf einer Neodym-Eisen-Bor-Legierung basieren.

5. System (7000) nach einem der Ansprüche 1 bis 4, derart, dass die Magnete (2001a, 2001b, 2002a, 2002b) an der Kathode (2003) innerhalb oder außerhalb der Kathodenkammer (2004) befestigt sind.

6. System (7000) nach einem der Ansprüche 1 bis 5, derart, dass die Dicke der Kathode (2003) höchstens 2 mm, insbesondere höchstens 1 mm, vorzugsweise etwa 0,2 mm beträgt.

7. System (7000) nach einem der Ansprüche 1 bis 6, derart, dass die Dicke der Anode (2004) zwischen 0,1 mm und 2 mm, vorzugsweise 0,5 mm beträgt.

8. System (7000) nach einem der Ansprüche 1 bis 7, derart, dass der Abstand zwischen den Magneten jedes Paares (2001, 2002) von Magneten (2001a, 2001b, 2002a, 2002b) zwischen 5 mm und 10 mm, vorzugsweise zwischen 5 mm und 8 mm beträgt.

9. System (7000) nach einem der Ansprüche 1 bis 8, derart, dass die Gesamtdicke des Druckmessgeräts (2000) höchstens 12 mm, insbesondere höchstens 11 mm, vorzugsweise höchstens 10 mm beträgt.

10. System (7000) nach einem der Ansprüche 1 bis 9, derart, dass die Magnete (2001a, 2001b, 2002a, 2002b) und die Öffnungen (2005a, 2005b) der Anode (2005) kreisförmig sind, der Durchmesser der Öffnungen (2005a, 2005b) der Anode (2005) zwischen 10 und 20 mm, insbesondere zwischen 14 mm und 19 mm beträgt und der Durchmesser der Magnete (2001a, 2001b, 2002a, 2002b) zwischen 14 und 30 mm beträgt.

11. System (7000) nach einem der Ansprüche 1 bis 10, wobei die Kathode (2003) ein U-förmiges Querschnittsprofil oder ein rechteckiges Querschnittsprofil aufweist, das an mindestens einer seiner Flächen, vorzugsweise einer seiner Seitenflächen, mit mindestens einer Öffnung (2004) versehen ist.

12. System (7000) nach einem der Ansprüche 1 bis 11, derart, dass es ferner mindestens ein primäres Vakuumdruckmessgerät umfasst, das im ersten Fach (7001) oder in einem anderen Fach neben dem ersten Fach (7001) angeordnet ist.

13. System (7000) nach einem der Ansprüche 1 bis 12, derart, dass das zweite Fach (7002) in der Verlängerung des ersten Fachs (7001) angeordnet werden kann, sodass, wenn das eingebettete System (7000) auf der Oberfläche (10001) eines flachen Substrats (10000), insbesondere an der Umfangskante eines flachen Substrats (10000), angeordnet ist, ein Teil des ersten Fachs (7001) sich außerhalb der Oberfläche 10001 des flachen Substrats (10000) befindet.

14. System (7000) nach einem der Ansprüche 1 bis 13, derart, dass es an seinem vorderen Teil ferner ein Passmittel (70005) aufweist, vorzugsweise in Form einer oberen Fase.

15. Verfahren zum Diagnostizieren des Sekundärvakuums in einer Linie zum Aufbringen von Dünnschichtstapeln auf einem flachen Substrat, wobei das Verfahren die folgenden Schritte umfasst:
- Anordnen mindestens eines eingebetteten Systems (7000) nach einem der Ansprüche 1 bis 14 auf einer Oberfläche (10001) mindestens eines flachen Substrats (10000);
- Weiterbewegen des flachen Substrats (10000) in der Gesamtheit oder einem Teil der Linie zum Aufbringen;
- Messen des Sekundärvakuumniveaus durch das eingebettete System (7000), wenn sich das flache Substrat (10000) weiterbewegt.

## Claims

1. Embedded system (7000) for measuring vacuum **characterized in** it comprises:
- a first compartment (7001) in which is situated a cold cathode ionization manometer (2000) comprising:
- at least two pairs (2001, 2002) of magnets (2001a, 2001b, 2002a, 2002b), preferably circular;
- a planar cathode (2003) forming a cathode chamber (2004) having an elongate, substantially parallelepiped shape and provided with at least one opening, preferably a lateral opening (2004a)
- a planar anode (2005) arranged in the cathode chamber, said anode comprising at least two openings (2005a, 2005b), preferably circular;
and wherein:
- the magnets (2001a, 2001b, 2002a, 2002b) have a magnetization of at least 795774 A/m and a maximum operating temperature of at least 80°C;
- the anode (2003) and the cathode (2005) consist of a non-magnetic conductive material;
- the cathode (2003) and the anode (2005) are arranged in the air gap of said pairs of magnets (2001a, 2001b, 2002a, 2002b) and the openings (2005a, 2005b) of the anode (2005) are located respectively between said pairs of magnets (2001, 2002) such that a plasma can be formed between each pair of magnets (2001, 2002), and
- the signs of the poles formed by each pair of magnets (2001, 2002) are such that in two neighboring plasmas, the magnetic fields are parallel, of the same intensity and of opposite direction,
said first compartment (7001) comprising at least one opening (7001a) allowing the outside atmosphere to come into contact with said manometer;
- a second compartment (7002) comprising an independent power supply source, an electronic control device, as well as an electronic storage medium and/or a telecommunication device;
and wherein:
- the first compartment (7001) and the second compartment (7002) are configured with respect to each other so that, when the embedded system (7000) is arranged on a planar substrate (10000), in particular on the peripheral rim of said planar substrate (10000), the thickness E of the embedded system (7000) is constant with respect to a surface (10001) of said planar substrate (10000) on which it is arranged.

2. System (7000) according to claim 1, wherein the magnets (2001a, 2001b, 2002a, 2002b) have a magnetization of at least 875352 A/m, or even of at least 954930 A/m.

3. System (7000) according to one of claims 1 to 2, wherein the maximum operating temperature of the magnets (2001a, 2001b, 2002a, 2002b) is at least 120°C, preferably at least 150°C, or even at least 200°C.

4. System (7000) according to one of claims 1 to 3, wherein the magnets (2001a, 2001b, 2002a, 2002b) are based on a neodymium alloy, in particular based on a neodymium-iron alloy, preferably based on a neodymium-iron-boron alloy.

5. System (7000) according to one of claims 1 to 4, wherein the magnets (2001a, 2001b, 2002a, 2002b) are attached to the cathode (2003) inside or outside the cathode chamber (2004).

6. System (7000) according to one of claims 1 to 5, wherein the thickness of the cathode (2003) is at most 2 mm, in particular at most 1 mm, preferably about 0.2 mm.

7. System (7000) according to one of claims 1 to 6, wherein the thickness of the anode (2004) is between 0.1 mm and 2 mm, preferably 0.5 mm.

8. System (7000) according to one of claims 1 to 7, wherein the spacing between the magnets of each pair (2001, 2002) of magnets (2001a, 2001b, 2002a, 2002b) is between 5 mm and 10 mm, preferably between 5 mm and 8 mm.

9. System (7000) according to one of claims 1 to 8, wherein the total thickness of the manometer (2000) is at most 12 mm, in particular at most 11 mm, preferably at most 10 mm.

10. System (7000) according to one of claims 1 to 9, wherein the magnets (2001a, 2001b, 2002a, 2002b) and the openings (2005a, 2005b) of the anode (2005) are circular, the diameter of said openings (2005a, 2005b) of the anode (2005) is between 10 and 20 mm, in particular between 14 mm and 19 mm, and the diameter of the magnets (2001a, 2001b, 2002a, 2002b) is between 14 and 30 mm.

11. System (7000) according to one of claims 1 to 10, wherein the cathode (2003) is a profile with a U-shaped cross-section or a profile with a rectangular cross-section provided with at least one opening (2004) on at least one of its faces, preferably one of its lateral faces.

12. The system (7000) according to one of claims 1 to 11, wherein it further comprises at least one primary vacuum manometer arranged in the first compartment (7001) or in another compartment adjacent to the first compartment (7001).

13. The system (7000) according to one of claims 1 to 12, wherein the second compartment (7002) can be arranged in the extension of the first compartment (7001) so that, when the embedded system (7000) is arranged on the surface (10001) of a planar substrate (10000), especially at the peripheral rim of a planar substrate (10000), a part of the first compartment (7001) is outside said surface 10001 of said planar substrate (10000).

14. The system (7000) according to one of claims 1 to 13, wherein it further comprises, on its front part, a space-saving means (70005), preferably in the form of an upper bevel.

15. A method for diagnosing secondary vacuum in a line for depositing stacks of thin films on a planar substrate, said method comprising the following steps:
- arranging on a surface (10001) of at least one planar substrate (10000) at least one embedded system (7000) according to any one of claims 1 to 14;
- moving the planar substrate (10000) in all or part of the deposition line;
- measuring the secondary vacuum level by the embedded system (7000) when the planar substrate (10000) moves.
